# EUROPÄISCHE PATENTSCHRIFT

(11) **EP 1 765 050 B1**
(45) Veröffentlichungstag und Bekanntmachung des Hinweises auf die Patenterteilung: **18.05.2011**
(21) Anmeldenummer: 06119768.7
(22) Anmeldetag: 30.08.2006
(51) Int. Cl.: H05K 13/00

(54) **Zuführvorrichtung für elektrische Bauteile**
Feeding apparatus for electrical components
Dispositif d'alimentation en composants électriques

(30) Priorität: 14.09.2005 DE 102005043881
(43) Veröffentlichungstag der Anmeldung: 21.03.2007
(73) Patentinhaber: ASM Assembly Systems GmbH & Co. KG, 81379 München (DE)
(72) Erfinder: Lintner, Albert, 83714, Miesbach (DE); Nitsch, Andreas, 86875, Bronnen (DE)
(74) Vertreter: Kuhlmann, Kai

(56) Entgegenhaltungen:
- EP-A- 1 465 217
- GB-A- 2 052 873
- JP-A- 59 167 407
- US-A1- 2003 057 229

## Beschreibung

Die Erfindung betrifft eine Zuführvorrichtung für elektrische Bauteile, sowie ein Bestücksystem mit einem Bestückautomaten und einer derartigen Zuführvorrichtung.

In der Bestücktechnik werden Zuführvorrichtungen zur Bereitstellung elektrischer Bauteile verwendet. Dabei kommen verschiedene Arten von Zuführvorrichtungen zum Einsatz. So gibt es beispielsweise so genannte Schüttgut-Feeder, welche mit elektrischen Bauteilen in Form von Schüttgut befüllt werden, und welche derart ausgebildet sind, dass sie die elektrischen Bauteile einzeln zum Abholen durch einen Bestückkopf bereitstellen. Davon zu unterscheiden sind die so genannten Gurt-Feeder, welche zum Transport und Zuführen von in Gurten gelagerten Bauteilen geeignet sind. Diesen Zuführvorrichtungen ist gemein, dass sie die Bauteile mit hoher Präzision und in einer definierten Lage zu einer Abholposition transportieren, an welcher die Bauteile von einer Handhabungsvorrichtung bzw. einem Bestückkopf abgeholt werden. Die Präzision bzw. die Reproduzierbarkeit der Bereitstellung der Bauteile an dieser definierten Abholposition durch die Zuführvorrichtungen gewinnt mit fortschreitender Miniaturisierung der Bauteile zunehmend an Bedeutung. Äußere Störeinflüsse, welche die Einhaltung der Abholposition durch die Zuführvorrichtung oder die Lage der Bauteile negativ beeinflussen, sind deshalb weitgehend auszuschalten. Da die elektrischen Bauteile häufig auch aufmagnetisierte Bestandteile (beispielsweise ferromagnetische Kontaktfüße) aufweisen, besteht die Gefahr, dass die Lage der Bauteile an der Abholposition durch äußere Magnetfelder gestört wird. Derartige Magnetfelder werden beispielsweise durch Elektromotoren oder Permanentmagnete hervorgerufen, welche in Bestücksystemen praktisch überall präsent sind. Ein auf ein Bauteil wirkendes Magnetfeld kann das Bauteil nicht nur relativ zur Abholposition verschieben, sondern dieses auch aufstellen. Dadurch kommt es zu Abholfehlern, welche den Bestückprozess negativ beeinträchtigen.

Auf der Offenlegungsschrift US 2003/0057229 A1 ist eine Zuführvorrichtung mit einer Positioniereinrichtung bekannt geworden, welche die elektrischen Bauteile an der Abholposition in eine definierte Lage bringt. Diese Vorrichtung weist jedoch den Nachteil auf, dass die Positioniereinrichtung kurz vor dem Abholen des Bauteiles durch den Bestückkopf vom Bauteil gelöst werden muss, um ein sicheres Abholen zu ermöglichen. Bei Einwirken eines Magnetfeldes kann es in diesem Moment zu einer Veränderung der Bauteilposition kommen. Diese Vorrichtung ist deshalb nur geeignet, um Lageveränderungen, welche durch Erschütterungen während des Bauteil-Transports in der Zuführvorrichtung auftreten, zu korrigieren. Ferner kann ein Aufstellen von Bauteilen nicht korrigiert werden.

Es ist deshalb die Aufgabe der vorliegenden Erfindung, eine Zuführvorrichtung und ein Bestücksystem mit einer derartigen Zuführvorrichtung zu liefern, bei welchen die Abholsicherheit der Bauteile an der Zuführvorrichtung gesteigert werden kann. Diese Aufgabe wird durch die Zuführvorrichtung und das Bestücksystem gemäß den unabhängigen Ansprüchen gelöst. Vorteilhafte Ausgestaltungen sind Gegenstand der Unteransprüche.

Die erfindungsgemäße Zuführvorrichtung weist gemäß Anspruch 1 einen Transportmechanismus auf, mittels welchem die Bauteile zu einer Abholposition transportierbar sind, an welcher die Bauteile von einer Handhabungseinrichtung, beispielsweise einem Bestückkopf, abholbar sind. Die Zuführvorrichtung umfasst ferner eine Abmagnetisierungseinrichtung, mittels welcher die Bauteile abmagnetisierbar sind. Durch die Abmagnetisierungseinrichtung werden die Bauteile entweder vollständig entmagnetisiert oder zumindest so weit abmagnetisiert, dass die Lage der Bauteile durch die gewöhnlich am Bestückautomaten oder in der Zuführvorrichtung selbst vorkommenden Magnetfelder nicht mehr verändert wird. Die Abmagnetisierung oder Entmagnetisierung kann durch Aussetzen des Bauteils einem magnetischen Wechselfeld mit zuerst ansteigender und dann sinkender Intensität durchgeführt werden. Durch die Abmagnetisierung bzw. Entmagnetisierung wird den Elementarmagneten innerhalb der ferromagnetischen Bestandteile des Bauteils die Vorzugsrichtung genommen. Dadurch wird eine Wechselwirkung zwischen dem Bauteil und einem auf das Bauteil wirkenden Magnetfeld unterbunden, oder anders gesagt, es wirkt keine resultierende Magnetkraft auf das Bauteil. Somit wird eine Veränderung der Lage der Bauteile an der Abholposition durch externe Magnetfelder, zumindest bis zu einer gewissen Feldstärke, sicher verhindert. Die präzise Einhaltung einer geforderten Lage der Bauteile an der Abholposition wird dadurch erheblich verbessert, was der gesamten Prozesssicherheit zugute kommt.

Gemäß einer Ausgestaltung der Zuführvorrichtung nach Anspruch 2 weist die Abmagnetisierungseinrichtung bzw. Entmagnetisierungseinrichtung eine Spule auf, welche mit einer Wechselspannungsquelle koppelbar ist, um ein Wechselmagnetfeld zu erzeugen. Durch diese Ausgestaltung der Abmagnetisierungseinrichtung ist es möglich, die Amplitude und die Frequenz des durch die Spule erzeugten magnetischen Wechselfeldes durch entsprechende Steuerung der Wechselspannungsquelle gemäß den Anforderungen einzustellen.

Gemäß Anspruch 3 ist die Wechselspannungsquelle derart ausgebildet, dass das von der Spule erzeugte Wechselmagnetfeld eine konstante Feldstärkenamplitude aufweist. Trotz der konstanten Feldstärkenamplitude werden die elektrischen Bauteile beim Vorbeibewegen an der Spule zur Abholposition zunächst einem ansteigenden und anschließend einem abklingenden Wechselmagnetfeld ausgesetzt. Dadurch kann eine Entmagnetisierung bzw. eine Abmagnetisierung erreicht werden.

Eine noch effektivere Ab- bzw. Entmagnetisierung kann dadurch erreicht werden, dass die Wechselspannungsquelle gemäß dem Anspruch 4 derart ausgebildet ist, dass das von der Spule erzeugte Wechselmagnetfeld eine variable Feldstärkenamplitude aufweist. Durch diese Ausgestaltung ergibt sich eine noch höhere Flexibilität bezüglich der Anpassung des Wechselmagnetfeldes an die verschiedenen Bauteile und Gegebenheiten der Zuführvorrichtung.

Gemäß den Ausgestaltungen der Zuführeinrichtung nach den Ansprüchen 5 und 6, weist die Zuführeinrichtung einen Transportkanal auf, in dem die Bauteile zu der Abholposition transportierbar sind, wobei die Spule so angeordnet ist, dass sie entweder den Transportkanal umwickelt oder ein Ende der Spule auf den Transportkanal gerichtet und ein anderes Ende dem Transportkanal abgewandt ist. Beide Ausführungen dienen der Konzentration des Wechselmagnetfelds auf einen sehr beschränkten Raum im Transportkanal, wodurch der Energieverbrauch für die Spule reduziert werden kann.

Gemäß dem Anspruch 7 ist die Wechselspannungsquelle derart ausgebildet, dass die Bauteile durch Einwirken des durch die Spule produzierten Wechselmagnetfeldes entmagnetisierbar sind. Durch die vollständige Entmagnetisierung wird die Beeinflussung der Lage der Bauteile an der Abholposition durch externe Magnetfelder nahezu vollständig unterbunden.

Ein Bestücksystem gemäß Anspruch 8 umfasst einen Bestückautomaten zum Bestücken von Substraten mit elektrischen Bauteilen und eine Zuführvorrichtung nach einem der vorangehenden Ansprüche. Bezüglich der Vorteile wird auf die Ausführungen zu den vorangehenden Ansprüchen verwiesen.

Im Folgenden wird ein Ausführungsbeispiel der vorliegenden Erfindung mit Bezug auf die beigefügten Figuren näher erläutert. In den Figuren sind:
Figur 1 eine schematische Darstellung eines erfindungsgemäßen Bestücksystems,
Figur 2 eine schematische Darstellung eines ersten Ausführungsbeispiels einer erfindungsgemäßen Zuführvorrichtung,
Figur 3, Figur 4 und Figur 5 jeweils eine vergrößerte Ansicht des Ausschnitts aus Figur 2 mit jeweils einer Ausführungsform der Abmagnetisierungseinrichtung,
Figur 6 eine schematische Darstellung eines zweiten Ausführungsbeispiels einer erfindungsgemäßen Zuführvorrichtung,
Figur 7 eine schematische Darstellung eines dritten Ausführungsbeispiels einer erfindungsgemäßen Zuführvorrichtung.

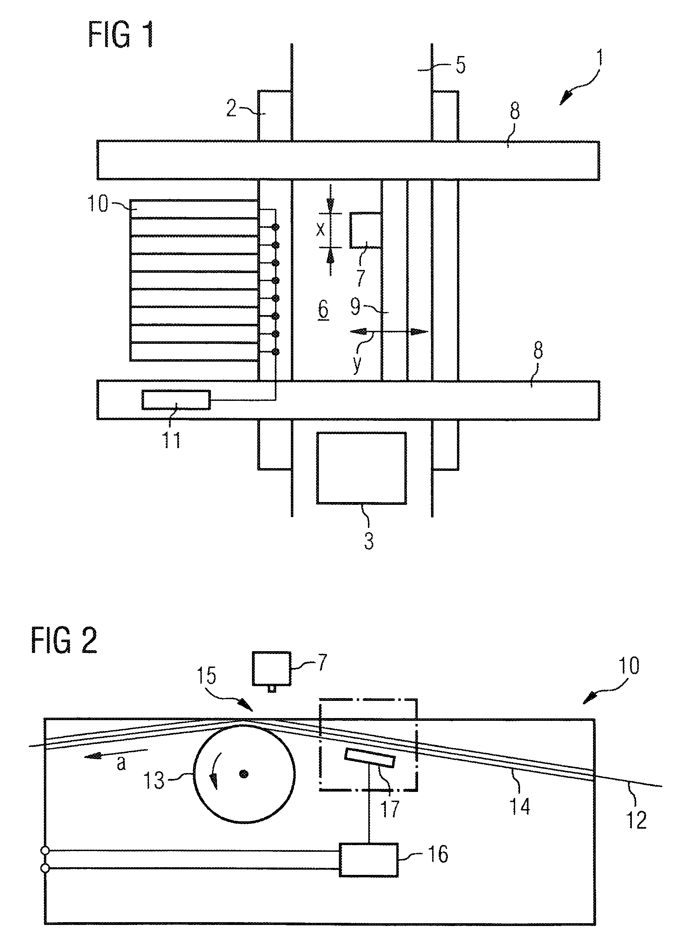

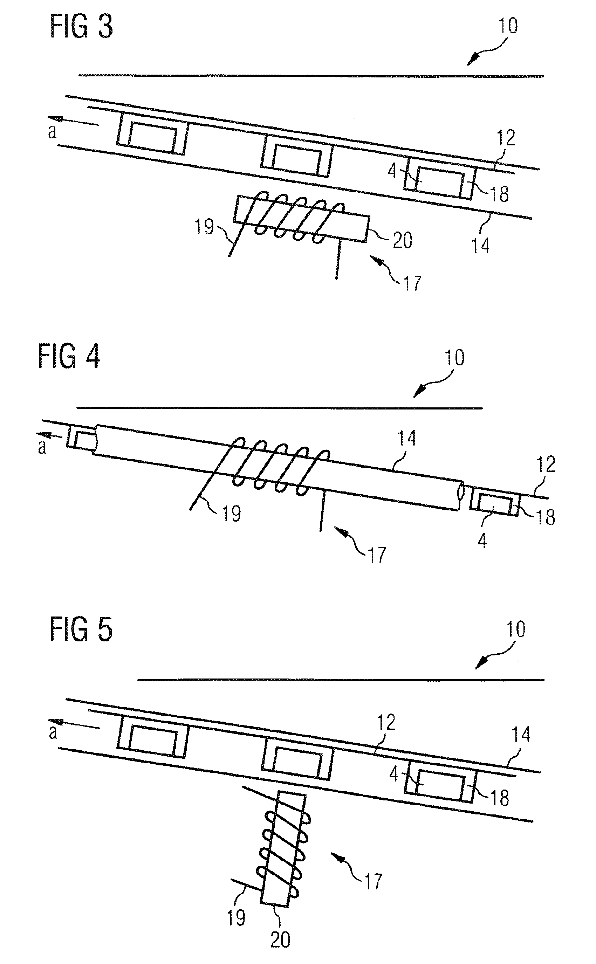

In Figur 1 ist ein erfindungsgemäßes Bestücksystem 1 schematisch dargestellt. Das Bestücksystem 1 umfasst einen Bestückautomaten 2 zum Bestücken von Substraten mit elektrischen Bauteilen (siehe Figur 3). Die zu bestückenden Substrate 3 werden mittels einer Transportstrecke 5 in einer Transportrichtung (Pfeil X) zu einem Bestückplatz 6 transportiert, um dort mit elektrischen Bauteilen (siehe Figur 3) bestückt und anschließend weiter transportiert zu werden. Der Bestückvorgang wird durch einen Bestückkopf 7 durchgeführt, welcher in einer zum Substrat 3 parallelen Ebene verfahrbar ist. Dazu ist der Bestückkopf 7 an einem Positioniersystem befestigt, welches aus zwei die Transportstrecke 5 brückenartig überspannende Trägern und einem entlang der Träger 8 in einer Richtung quer zur Transportrichtung (Pfeil Y) beweglichen Positionierarm 9 besteht. Der Bestückkopf 7 ist an dem Positionierarm 9 parallel zur Transportstrecke 5 (Pfeil X) beweglich angeordnet. Seitlich der Transportstrecke 5 sind mehrere erfindungsgemäße Zuführvorrichtungen 10 für die elektrischen Bauteile 4 angeordnet. Der Bestückkopf 7 wird mittels des Positioniersystems zu den Zuführvorrichtungen 10 bewegt, nimmt dort die Bauteile 4 von den Zuführvorrichtungen 10 auf und wird zurück zu dem Substrat 3 bewegt, um das Substrat 3 mit den aufgenommenen Bauteilen zu bestücken. Der Bestückautomat 2 verfügt ferner über eine Wechselspannungsquelle 11, mit welcher die Zuführeinrichtungen 10 verbunden sind. Alternativ dazu kann jedoch auch jede Zuführeinrichtung 10 selbst eine eigene Wechselspannungsquelle 11 aufweisen. Die Bedeutung der Wechselspannungsquelle 11 wird im Laufe der weiteren Beschreibung erläutert.

In Figur 2 ist die erfindungsgemäße Zuführvorrichtung 10 schematisch dargestellt. Dabei handelt es sich um eine Zuführvorrichtung 10, welche sich zum Zuführen von in einem Gurt 12 gelagerten Bauteilen eignet. Dazu umfasst die Zuführvorrichtung 10 ein Transportrad 13, welches an seinem Außenumfang stachelartige Transportstifte (nicht dargestellt) aufweist, welche in entsprechende Perforationen (nicht dargestellt) am Gurt 12 eingreifen und diesen dadurch bei Drehung des Transportrads in einer Förderrichtung (Pfeil a) transportieren. Auf diese Weise wird ein in einem Transportkanal 14 der Zuführvorrichtung 10 eingeführter Gurt 12 in der Förderrichtung zu einer Abholposition 15 der Zuführvorrichtung 10 transportiert, an welcher die Bauteile 4 dem Gurt 12 durch den Bestückkopf 7 entnommen werden können. Der leere Gurt 12 wird über einen Ausgang des Transportkanals entsorgt. Die Zufuhr des Gurtes durch das Transportrad 13 geschieht dabei nicht kontinuierlich, sondern in schrittweise in definierten Schrittweiten.

Wie aus Figur 2 ersichtlich ist, umfasst die Zuführvorrichtung 10 ferner eine Steuereinrichtung 16, welche Abläufe innerhalb der Zuführvorrichtung 10 koordiniert und steuert. Die Steuereinrichtung 16 ist im angekoppelten Zustand über zwei entsprechende Schnittstellen mit einer Energieversorgung (nicht dargestellt), der Wechselspannungsquelle 11 und einer Zentralsteuerung (nicht dargestellt) auf Seiten des Bestückautomaten 2 verbunden. In unmittelbarer Nähe des Transportkanals für den Gurt 12 weist die erfindungsgemäße Zuführvorrichtung 10 eine Ab- bzw. Entmagnetisierungseinrichtung 17 auf, welche derart ausgebildet und angeordnet ist, dass mit ihr die zugeführten Bauteile 4 entweder vollständig entmagnetisiert oder zumindest abmagnetisierbar sind. Im Ausführungsbeispiel der Figur 2 ist die Abmagnetisierungsvorrichtung im angekoppelten Zustand über die Steuereinrichtung 16 mit der Wechselspannungsquelle 11 verbunden. Die Wechselspannungsquelle 11 kann sich alternativ auch in der Zuführvorrichtung 10 befinden, wobei die Abmagnetisierungseinrichtung 17 auch in diesem Fall über die Steuereinrichtung 16 mit der Wechselspannungsquelle 11 verbunden ist.

In den Figuren 3 bis 5 ist der mittels gestrichelter Linien abgegrenzte Ausschnitt in Figur 2 vergrößert dargestellt. Die Figuren 3 bis 5 zeigen jeweils Ausgestaltungen der Abmagnetisierungseinrichtung 17. Zu erkennen ist der Gurt 12, welcher taschenartige Vertiefungen 18 aufweist, in denen die elektrischen Bauteile 4 gelagert sind. Mit dem Pfeil a ist die Förderrichtung angedeutet, mittels welcher der Gurt 12 durch das Transportrad 13 schrittweise zur Abholposition 15 transportiert wird.

Die Bauteile 4 weisen häufig magnetisierbare Nickel- oder Eisenanteile auf. Diese magnetisierbaren Anteile werden häufig schon bei der Herstellung, beim Einbringen in den Gurt 12 oder bei Transportvorgängen durch auf sie einwirkende, relativ starke Magnetfelder vormagnetisiert. Je nachdem, welche Magnetfelder im Bereich des Bestücksystems 1 auf diese vormagnetisierten Bauteile 4 einwirken, können diese in Wechselwirkung treten und die Lage der Bauteile 4 in den Vertiefungen 18 soweit beeinflussen, dass diese z. B. verkippen oder verdrehen.

Der Erfindung liegt der Gedanke zugrunde, die Veränderung der Lage der Bauteile 4 an der Abholposition 15 durch von außen einwirkende Magnetfelder dadurch zu unterbinden, indem die Bauteile 4 durch die Abmagnetisierungseinrichtung 17 vollständig entmagnetisiert werden oder zumindest soweit abmagnetisiert werden, dass die Restmagnetisierung des Bauteils 4 nicht mehr ausreicht, um das Bauteil 4 aufgrund Einwirkung von Magnetfeldern in seiner Lage zu verändern. Dies wird erfindungsgemäß dadurch erreicht, dass mittels der Abmagnetisierungseinrichtung 17 ein magnetisches Wechselfeld erzeugt wird, welches auf die Bauteile 4 in definierter Weise einwirkt. Die Grundlagen der Abmagnetisierung bzw. Entmagnetisierung ferromagnetischer Stoffe ist aus einschlägigen Standardwerken bekannt und wird an dieser Stelle nicht näher dargestellt.

Wie aus den Ausführungsbeispielen der Figuren 3 bis 5 hervorgeht, weist die Abmagnetisierungseinrichtung 17 eine Spule 19 auf, die über die Steuereinrichtung 16 an die Wechselspannungsquelle 11 im Bestückautomaten 2 anschließbar ist, um ein Wechselmagnetfeld zu erzeugen, welches auf die im Gurt 12 gelagerten Bauteile 4 einwirkt. Im Ausführungsbeispiel der Figur 3 ist die Spule 19 um einen Magnetkern 20 zur Verstärkung des Magnetfeldes herumgewickelt, wobei sich die Spule 19 und der Magnetkern 20 derart in der Nähe des Transportkanals für den Gurt 12 befindet, dass das von Wechselmagnetfeld mit ausreichend hoher Feldstärke auf die Bauteile 4 wirkt. Im Ausführungsbeispiel der Figur 4 ist die Spule 19 dagegen um den Transportkanal 14 für die Bauteile 4 herumgewickelt. Alternativ kann die Spule 19, wie in Figur 5 dargestellt, auch derart angeordnet sein, dass ein Ende der Spule 19 dem Transportkanal 14 zugewandt ist und das andere Ende der Spule 19 dem Transportkanal 14 abgewandt ist. Die Anordnungen der Spule 19 gemäß den Figuren 4 und 5 bewirken eine weitgehende Konzentration des Wechselmagnetfeldes auf den Transportkanal 14, wodurch der Energieverbrauch für die Spule 19 reduziert werden kann.

Zur Entmagnetisierung ist die ferromagnetische Probe, in diesem Fall die Bauteile 4, einem magnetischen Wechselfeld mit abnehmender Amplitude auszusetzen. Die Abnahme der Amplitude des Wechselmagnetfeldes kann dabei auf zweierlei Arten realisiert werden. Bei ruhendem Bauteil 4 wird die Amplitude des Wechselmagnetfeldes durch Steuerung mittels einer Elektronik entsprechend reduziert. Bei einem bewegten Bauteil 4 kann die Feldstärkenamplitude des Wechselmagnetfeldes konstant bleiben, wobei die Abnahme der Amplitude der auf das Bauteil 4 wirkenden Feldstärke durch die Relativbewegung des Bauteils 4 zum Feld entsprechend räumlich zeitlich gesteuert wird.

Wie oben erwähnt wurde, werden die Bauteile 4 schrittweise zu der Abholposition 15 gefördert. Dies bedeutet, dass an bestimmten Positionen entlang des Transportkanals die Bauteile 4 zumindest zeitweise in Ruhe sind, während an anderen Positionen entlang des Transportkanals 14 die Bauteile 4 vorbeibewegt werden. Ist die Abmagnetisierungseinrichtung 17 bzw. die Spule 19 an einem Ort entlang des Transportkanals 14 vorgesehen, an den die Bauteile 4 zumindest zeitweise in Ruhe sind, so ist die Abnahme der Amplitude des Wechselmagnetfeldes durch die Steuereinrichtung 16 der Zuführvorrichtung 10 zeitlich so zu steuern, dass der Ab- bzw. Entmagnetisierungseffekt entsprechend eintritt. Ist die Abmagnetisierungseinrichtung 17 bzw. Spule 19 hingegen an einer Position entlang des Transportkanals 14 angeordnet, an den die Bauteile 4 lediglich vorbeigeführt werden, so kann das durch die Spule 19 erzeugte Wechselmagnetfeld eine konstante Feldstärkenamplitude aufweisen. In diesem Fall kann jedoch aus Optimierungsgründen zusätzlich eine Abnahme der Feldstärkenamplitude durch die Steuereinrichtung 16 vorgenommen werden. In beiden Fällen wird die Frequenz des Wechselmagnetfeldes durch die Steuereinrichtung 16 gesteuert.

Das Ausführungsbeispiel bezieht sich auf eine Zuführvorrichtung 10, welche sich zum Zuführen von in einem Gurt 12 gelagerten Bauteilen eignet. Der Grundgedanke der Erfindung, nämlich das Vorsehen einer Abmagnetisierungseinrichtung 17, mittels welcher die zugeführten Bauteile 4 abmagnetisierbar sind, ist jedoch analog auch auf andere Arten von Zuführvorrichtungen 10 übertragbar.

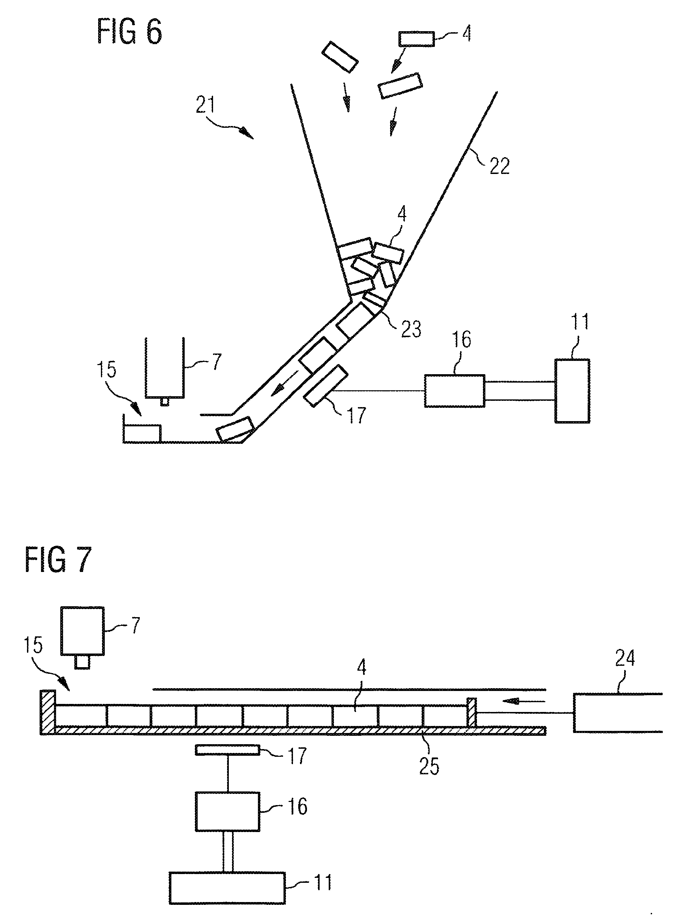

Wie in Figur 6 schematisch dargestellt, ist eine entsprechende Abmagnetisierungseinrichtung 17 beispielsweise auch bei einem so genannten Schüttgut-Feeder, bei welchem die Bauteile 4 in Form von Schüttgut in einem Auffangtrichter 22 eingefüllt werden und dann mittels eines Sortierungsmechanismus 23 vereinzelt und zu der Abholposition 15 befördert werden, anwendbar.

Ein weiteres Beispiel ist in Figur 7 dargestellt. Die Bauteile 4 werden hier mittels eines elektrischen oder pneumatischen Schiebers 24 aus einem Bauteilmagazin 25 sukzessive zur Abholposition 15 geschoben. Auch hier ist eine Abmagnetisierungseinrichtung 17 entsprechend vorgesehen.

Als weitere Alternative für eine Zuführeinrichtung, auf die der Erfindungsgedanke anwendbar wäre, ist ein so genannter Tray-Feeder (nicht dargestellt) zu nennen. Bei dem Tray-Feeder sind die Bauteile auf einer Art Tablett gelagert und werden dem Bestückautomaten über entsprechende Handhabungsvorrichtung zugeführt. Auch eine derartiger Tray-Feeder kann entsprechend mit einer Abmagnetisierungseinrichtung ausgestattet sein.

Durch die Abmagnetisierung bzw. Entmagnetisierung der Bauteile 4 wird verhindert, dass diese aufgrund von insbesondere an der Abholposition 15 wirkenden Magnetfeldern eine unerwünschte Lageveränderung erfahren, was den Abholprozess der Bauteile 4 durch den Bestückkopf 7 negativ beeinflusst. Die abmagnetisierten bzw. entmagnetisierten Bauteile 4 verhalten sind passiv und treten, zumindest bis zu einer gewissen Feldstärke, nicht mehr mit externen Magnetfeldern in Wechselwirkung, sodass sie durch die auf sie wirkende Magnetkraft ihre Lage nicht mehr verändern. Dadurch werden die Abholsicherheit und der gesamte Bestückprozess sicherer gemacht.

### Bezugszeichenliste:

- 1: Bestücksystem
- 2: Bestückautomat
- 3: Substrat
- 4: Bauteile
- 5: Transportstrecke
- 6: Bestückplatz
- 7: Bestückkopf
- 8: Träger
- 9: Positionierarm
- 10: Zuführvorrichtung
- 11: Wechselspannungsquelle
- 12: Gurt
- 13: Transportrad
- 14: Transportkanal
- 15: Abholposition
- 16: Steuereinrichtung
- 17: Abmagnetisierungseinrichtung
- 18: Vertiefung
- 19: Spule
- 20: Magnetkern
- 21: Schüttgut-Feeder
- 22: Auffangtrichter
- 23: Sortierungsmechanismus
- 24: Schieber
- 25: Bauteilmagazin

## Patentansprüche

1. Zuführvorrichtung (10) für elektrische Bauteile (4), mit einem Transportmechanismus (13), mittels welchem die Bauteile (4) zu einer Abholposition (15) transportierbar sind, an welcher die Bauteile (4) von einer Handhabungseinrichtung (7) abholbar sind, wobei eine Abmagnetisierungseinrichtung (17) vorgesehen ist, mittels welcher die Bauteile (4) abmagnetisierbar sind, **dadurch gekennzeichnet, dass** die Abmagnetisierungseinrichtung (17) derart angeordnet ist, dass die Bauteile (4) vor dem Abholen durch die Handhabungseinrichtung (7) an der Abholposition (15) abmagnetisiert werden.

2. Zuführvorrichtung (10) nach Anspruch 1, **dadurch gekennzeichnet, dass** die Abmagnetisierungseinrichtung (17) eine Spule (19) aufweist, welche mit einer Wechselspannungsquelle (11) koppelbar ist, um ein Wechselmagnetfeld zu erzeugen.

3. Zuführvorrichtung (10) nach Anspruch 2, **dadurch gekennzeichnet, dass** die Wechselspannungsquelle (11) derart ausgebildet ist, dass das von der Spule (19) erzeugte Wechselmagnetfeld eine konstante Feldstärkenamplitude aufweist.

4. Zuführvorrichtung (10) nach Anspruch 2, **dadurch gekennzeichnet, dass** die Wechselspannungsquelle (11) derart ausgebildet ist, dass das von der Spule (19) erzeugte Wechselmagnetfeld eine variable Feldstärkenamplitude aufweist.

5. Zuführeinrichtung (10) nach einem der Ansprüche 2 bis 4, **dadurch gekennzeichnet, dass** ein Transportkanal (14) vorgesehen ist, in dem die Bauteile (4) zu der Abholposition (15) transportierbar sind, und wobei die Spule (19) derart angeordnet ist, dass ein Ende der Spule (19) auf den Transportkanal (14) gerichtet ist und ein anderes Ende der Spule (19) von dem Transportkanal (14) abgewandt ist.

6. Zuführeinrichtung (10) nach einem der Ansprüche 2 bis 4, **dadurch gekennzeichnet, dass** ein Transportkanal (14) vorgesehen ist, in dem die Bauteile (4) zu der Abholposition (15) transportierbar sind, wobei die Spule (19) um den Transportkanal (14) gewickelt ist.

7. Zuführvorrichtung (10) nach einem der Ansprüche 1 bis 6, **dadurch gekennzeichnet, dass** die Wechselspannungsquelle (11) derart ausgebildet ist, dass die Bauteile (4) durch Einwirken des Wechselmagnetfelds entmagnetisierbar sind.

8. Bestücksystem (1) mit einem Bestückautomaten (2) zum Bestücken von Substraten (3) mit elektrischen Bauteilen (4) und einer Zuführvorrichtung (10) nach einem der Ansprüche 1 bis 7.

## Claims

1. A feeder device (10) for electrical components (4), comprising a transport mechanism (13) by means of which the components (4) are transportable to a collection position (15) in which the components (4) can be collected by a handling means (7), a demagnetising means (17) being provided by means of which the components (4) can be demagnetised, **characterised in that** the demagnetising means (17) is arranged in such a way that the components (4) are demagnetised before being collected by the handling means (7) in the collection position (15).

2. The feeder device (10) according to claim 1, **characterised in that** the demagnetising means (17) comprises a coil (19) which can be coupled to an AC voltage source (11) so as to generate an alternating magnetic field.

3. The feeder device (10) according to claim 2, **characterised in that** the AC voltage source (11) is formed in such a way that the alternating magnetic field generated by the coil (19) has a constant field strength amplitude.

4. The feeder device (10) according to claim 2, **characterised in that** the AC voltage source (11) is formed in such a way that the alternating magnetic field generated by the coil (19) has a variable field strength amplitude.

5. The feeder device (10) according to any one of claims 2 to 4, **characterised in that** a transport duct (14) is provided in which the components (4) are transportable to the collection position (15), and the coil (19) being arranged in such a way that one end of the coil (19) is directed the transport duct (14) and another end of the coil (19) is averted from the transport duct (14).

6. The feeder device (10) according to any one of claims 2 to 4, **characterised in that** a transport duct (14) is provided in which the components (4) are transportable to the collection position (15), the coil (19) being wound around the transport duct (14).

7. The feeder device (10) according to any one of claims 1 to 6, **characterised in that** the AC voltage source (11) is formed in such a way that the components (4) can be demagnetised by the effect of the alternating magnetic field.

8. A placement system (1) comprising a placement machine (2) for populating substrates (3) with electrical components (4) and comprising a feeder device (10) according to any one of claims 1 to 7.

## Revendications

1. Dispositif d'alimentation (10) pour des composants (4) électriques, comprenant un mécanisme de transport (13), au moyen duquel les composants (4) peuvent être transportés à une position d'enlèvement (15), sur laquelle les composants (4) peuvent être enlevés par un dispositif de manipulation (7), un dispositif de démagnétisation (17) étant prévu, au moyen duquel les composants (4) peuvent être démagnétisés, **caractérisé en ce que** le dispositif de démagnétisation (17) est disposé de telle sorte que les composants (4) sont démagnétisés avant l'enlèvement par le dispositif de manipulation (7) sur la position d'enlèvement (15).

2. Dispositif d'alimentation (10) selon la revendication 1, **caractérisé en ce que** le dispositif de démagnétisation (17) présente une bobine (19) qui peut être couplée avec une source de tension alternative (11) pour générer un champ magnétique alternatif.

3. Dispositif d'alimentation (10) selon la revendication 2, **caractérisé en ce que** la source de tension alternative (11) est conçue de telle sorte que le champ magnétique alternatif généré par la bobine (19) présente une amplitude constante d'intensité de champ.

4. Dispositif d'alimentation (10) selon la revendication 2, **caractérisé en ce que** la source de tension alternative (11) est conçue de telle sorte que le champ magnétique alternatif généré par la bobine (19) présente une amplitude variable d'intensité de champ.

5. Dispositif d'alimentation (10) selon l'une quelconque des revendications 2 à 4, **caractérisé en ce qu'**il est prévu un canal de transport (14) dans lequel les composants (4) peuvent être transportés à la position d'enlèvement (15), et la bobine (19) étant disposée de telle sorte qu'une extrémité de la bobine (19) est orientée vers le canal de transport (14) et une autre extrémité de la bobine (19) est opposée au canal de transport (14).

6. Dispositif d'alimentation (10) selon l'une quelconque des revendications 2 à 4, **caractérisé en ce qu'**il est prévu un canal de transport (14) dans lequel les composants (4) peuvent être transportés à la position d'enlèvement (15), la bobine (19) étant enroulée autour du canal de transport (14).

7. Dispositif d'alimentation (10) selon l'une quelconque des revendications 1 à 6, **caractérisé en ce que** la source de tension alternative (11) est conçue de telle sorte que les composants (4) peuvent être démagnétisés par l'effet du champ magnétique alternatif.

8. Système d'équipement (1) comprenant un automate d'équipement (2) pour l'équipement de substrats (3) avec des composants (4) électriques et un dispositif d'alimentation (10) selon l'une quelconque des revendications 1 à 7.
